# EUROPÄISCHE PATENTSCHRIFT

(11) **EP 1 045 046 B1**
(45) Veröffentlichungstag und Bekanntmachung des Hinweises auf die Patenterteilung: **25.05.2005**
(21) Anmeldenummer: 00106234.8
(22) Anmeldetag: 22.03.2000
(51) Int. Cl.: C30B 15/10, C30B 35/00, C03C 15/00, C03B 19/09, C03C 19/00, C03B 23/00

(54) **Herstellungsverfahren für einen Quarzglas-Tiegel**
Process for manufacturing a quartz glass crucible
Procédé de fabrication d'un creuset en verre de quartz

(30) Priorität: 16.04.1999 DE 19917288
(43) Veröffentlichungstag der Anmeldung: 18.10.2000
(73) Patentinhaber: Heraeus Quarzglas GmbH & Co. KG, 63450 Hanau (DE)
(72) Erfinder: Fabian, Heinz, 63792 Grossostheim (DE); Arndt, Martin, Dr., 06749 Bitterfeld (DE); Leist, Johann, 63674 Altenstadt (DE); Gertig, Udo, 63867 Johannesberg (DE); Englisch, Wolfgang, Dr., 65779 Kelkheim (DE)

(56) Entgegenhaltungen:
- EP-A- 0 338 914
- DE-A- 19 713 014
- US-A- 4 528 163
- PATENT ABSTRACTS OF JAPAN vol. 199, no. 511, 26. Dezember 1995 (1995-12-26) & JP 07 196397 A (TOSHIBA CERAMICS), 1. August 1995 (1995-08-01)
- PATENT ABSTRACTS OF JAPAN vol. 14, no. 459, 4. Oktober 1990 (1990-10-04) & JP 02 188489 A (MITSUBISHI METEL CORP), 24. Juli 1990 (1990-07-24)

## Beschreibung

Die vorliegende Erfindung betrifft Verfahren zur Herstellung eines Quarzglas-Tiegels durch Bereitstellen eines Tiegelkörpers mit Innenoberfläche aus Quarzglas.

Quarzglas-Tiegel werden beispielsweise zum Ziehen von Einkristallen aus einer Metallschmelze nach dem Czochralski-Verfahren eingesetzt. Ein gattungsgemäßer Tiegel und ein Herstellungsverfahren dafür sind in der US-A 4,528,163 beschrieben. Der bekannte Tiegel besteht aus einem Tiegel-Basiskörper aus natürlichem Quarz, mit einem Boden, der mit einer im wesentlichen zylinderförmigen Seitenwand verbunden ist. Der Tiegel weist eine Innenschicht aus transparentem, synthetisch hergestelltem Quarzglas auf, die durch Verglasen einer Körnungsschicht aus synthetisch hergestellter SiO₂-Körnung gebildet wird.

Für die Herstellung des bekannten Quarzglas-Tiegels wird in einem ersten Verfahrensschritt einer um ihre Mittelachse rotierenden metallischen Schmelzform kristalline Körnung aus natürlichem Quarz zugeführt, und daraus an der Innenwandung der Schmelzform eine gleichmäßig dicke, tiegelförmige Außenschicht geformt. Unter anhaltender Rotation der Schmelzform wird anschließend synthetisch hergestelltes SiO₂-Pulver eingestreut, das sich an der Innenwandungen der Außenschicht als Körnungsschicht niederschlägt, die anschließend unter Bildung einer transparenten, mit der Außenschicht fest verbundenen, verschleißfesten Innenschicht aufgeschmolzen wird. Zur Vermeidung von Kristallisationskeimen und Blasen in der Innenschicht wird dabei die Schmelztemperatur so hoch eingestellt, daß die eingestreute Körnung vollständig aufschmilzt. Die innere Oberfläche des bekannten Quarzglas-Tiegels wird somit von einer glatten, amorphen Innenschicht gebildet. Es ist auch ein ähnliches Verfahren bekannt, bei dem an der Innenwandung der Schmelzform eine tiegelförmige Außenschicht aus kristalliner Quarzkörnung und eine Körnungsschicht aus synthetisch hergestelltem SiO₂-Pulver fixiert werden, indem an der Innenwandung der Schmelzform ein Unterdruck erzeugt wird. Außenschicht und Körnungsschicht werden anschließend gemeinsam verglast.

Beim Ziehen eines Einkristalls nach dem Czochralski-Verfahren, beispielsweise beim Ziehen eines Silizium-Einkristalls aus der Silizum-Schmelze, wird ein Impfkristall mit vorgegebener Orientierungsrichtung in die Schmelze eingetaucht und dann langsam hochgezogen. Impfkristall und Schmelze rotieren dabei gegenläufig. Die Oberflächenspannung zwischen Impfkristall und Schmelze bewirkt, daß mit dem Impfkristall auch ein wenig Schmelze abgezogen wird, die allmählich erkaltet und dadurch zu dem stetig weiterwachsenden Einkristall erstarrt. Dabei kann es aber vorkommen, daß der Impfkristall abreißt, so daß der sogenannte "Ansetzprozess" neu begonnen werden muß. Die Zeitspanne bis zum eigentlichen Ziehen des Einkristalls kann mehrere Stunden betragen, so daß sich die Prozeßdauer entsprechend verlängert. Ein langer Ansetzprozess ist ein erheblicher Kostenfaktor. Darüberhinaus nimmt mit der Prozeßdauer die thermische und chemische Belastung für den Quarzglas-Tiegel entsprechend zu.

Aus EP-A 0 338 914 sind weiterhin Verfahren und Tiegel für die Halbleiter-Kristallzüchtung bekannt. Die Innenwände der Tiegel nach EP-A 0 338 914 weisen regelmäßig angeordnete Unebenheiten auf, deren Unebenheitswinkel in Bezug auf eine gewünschte Be- und Entnetzung zwischen Flüssigkeit (Metallschmelze) und Tiegel bzw. Ablösung des erstarrten Kristallklumpens bei der Abkühlung im Tiegel optimiert sind. Zur Erzeugung dieser regelmäßigen Unebenheiten mit konstanten Unebenheitswinkeln werden klassische, mechanische Bearbeitungsmethoden zum Abtragen (Drehen, Bohren, Fräsen, Gewindeschneiden, Sandstrahlen) oder Hinzufügen von Materie, wie beispielsweise Ankleben von Teilchen entsprechender Komgröße oder Anbringen einer rauhen Struktur, wie etwa Fasern oder Gewebe offenbart.

Der Erfindung liegt die Aufgabe zugrunde ein einfaches und kostengünstiges Verfahren für die Herstellung eines Quarzglas-Tiegels anzugeben, der den Ansetzprozess erleichtert.

Hinsichtlich des Verfahrens zur Herstellung eines derartigen Quarzglas-Tiegels wird die oben genannte Aufgabe ausgehend von dem eingangs beschriebenen Verfahren erfindungsgemäß dadurch gelöst, daß die Innenoberfläche im Bereich einer Ansetzzone durch Ätzen mittels einer Ätzlösung aufgerauht wird, wobei eine Vielzahl von Vertiefungen, die einen Abstand von maximal 5 mm zueinander haben, ausgebildet werden.

Die Innenoberfläche kommt mit der Metallschmelze beim Kristallziehen in Kontakt. Die Ansetzzone umfaßt denjenigen Bereich der Innenoberfläche des Quarzglas-Tiegels, in dem sich der Schmelzspiegel während des Ansetzprozesses befindet. Es handelt es sich um einen an der Tiegel-Innenwandung umlaufenden Bereich. Es hat sich gezeigt, daß für den Erfolg des Ansetzprozesses eine vibrations- und schwingungsfreie Schmelzoberfläche entscheidend ist. Schwingungen der Schmelzoberfläche, wie sie beispielsweise durch die Rotation von Schmelze und Impfkristall oder durch das Eintauchen des Impfkristalls verursacht werden können, werden durch den erfindungsgemäßen Tiegel gedämpft. Die Aufrauhung der Innenoberfläche im Bereich der Ansetzzone bewirkt eine Stabilisierung und Beruhigung des Schmelzspiegels. In der Ansetzzone werden Vertiefungen erzeugt, die ein phasengleiches Benetzen oder Nichtbenetzen der Oberfläche durch die Metallschmelze verhindern. Diese Maßnahme verhindert die Entstehung und das Aufschaukeln von Schwingungen oder reduziert zumindest deren Intensität, so daß Schwankungen des Schmelzspiegels vermindert oder gedämpft werden. Damit die Aufrauhung eine entsprechende Wirkung entfalten kann, wird mindestens im Bereich der Ansetzzone ein Rauhheitsprofil erzeugt, das eine Vielzahl von Vertiefungen umfaßt, die einen Abstand von maximal 5 mm zueinander haben. Die Vertiefungen können unterhalb der restlichen Innenoberfläche liegen, aber auch auf dieser oder darüber, wenn auf der Innenoberfläche zusätzliche Quarzglasschichten aufgebracht werden. Die Aufrauhung muß nicht auf den Bereich der Ansetzzone beschränkt sein. Es ist für den Erfolg der erfindungsgemäßen Lehre auch nicht erforderlich, daß die Oberfläche im Bereich der umlaufenden Ansetzzone lückenlos aufgerauht ist. Wesentlich ist, daß sich im Bereich des Schmelzspiegels eine aufgerauhte Oberfläche mit einer Vielzahl von Vertiefungen befindet.

Die schwingungsdämpfende Wirkung der Aufrauhung ist umso ausgeprägter, je ausgeprägter das Rauheitsprofil im Bereich der Ansetzzone ist. Vorteilhafterweise wird ein dichtes Rauheitsprofil eingestellt, bei dem die Vertiefungen einen Abstand von maximal 1 mm, vorzugsweise maximal 100 µm zueinander haben.

Für die Erzeugung der Rauhigkeit der Innenoberfläche haben sich mehrere Verfahrensweisen als geeignet erwiesen, die alternativ oder kumulativ angewandt werden können und die im folgenden näher erläutert werden.

Erfindungsgemäß wird die Innenoberfläche durch Ätzen mittels einer Ätzlösung aufgerauht. Ein geeignetes Ätzverfahren und eine geeignete Ätzlösung sind beispielsweise in der DE-A 197 13 014 beschrieben. Das Ätzverfahren ist einfach durchführbar und es kann gleichzeitig zur Reinigung der Tiegel-Innenoberfläche dienen. Es kann auch auf einen Bereich um die Ansetzzone beschränkt werden. Durch Ätzen werden saubere Innenoberflächen mit hügeliger Struktur erhalten.

Bei einer anderen Verfahrensvariante werden in der Innenoberfläche Kratzer erzeugt. Derartige Kratzer lassen sich sehr einfach durch Schleifwerkzeuge, zum Beispiel Diamantwerkzeuge oder durch lose Schleifmittel erzeugen. Die Innenoberfläche kann auch durch Laserbearbeitung strukturiert werden, wobei auch Kratzstrukturen mit definierten Mustern erzeugt werden können. Als günstig im Hinblick auf eine einfache Herstellung des Quarzglas-Tiegels hat sich eine zeugung der Kratzer durch Einwirkung eines Partikelstromes auf die Oberfläche erwiesen, wobei in diesem Zusammenhang ein Partikelstrom, der gefrorene CO₂-Pellets enthält, eingesetzt wird. Die CO₂-Pellets verdampfen rückstandsfrei, so daß Verunreinigungen - wie etwa Abrasivmittel-Reste - vermieden werden.

Eine weitere Verfahrensvariante besteht darin, daß das Bereitstellen des Tiegelkörpers ein Einstreuen von SiO₂-Körnung in eine Schmelzform umfaßt, wobei der SiO₂-Körnung eine Zusatzkomponente beigemischt wird, die beim Erhitzen unter Freisetzung eines Gases reagiert, wobei durch die Freisetzung des Gases eine porenhaltige Blasenschicht im Bereich der Ansetzzone erzeugt wird, die nach dem Öffnen der Blasen eine Vielzahl von Vertiefungen freilegt. Die porenhaltige Blasenschicht kann leicht auf den Bereich der Ansetzzone beschränkt werden, indem die Zusatzkomponente nur während der Herstellung der Innenoberfläche in diesem Bereich beigemischt wird. Bei der Zusatzkomponente kann es sich beispielsweise um Si₃N₄ oder AIN handeln, das beim Erhitzen unter Freisetzung stickstoffhaltiger Gase reagiert.

Nachfolgend wird die Erfindung anhand von Ausführungsbeispielen und anhand der Patentzeichnung näher erläutert. In der Patentzeichnung zeigen im einzelnen:
- **Figur 1**: ein Herstellungsverfahren für einen Quarzglas-Tiegel nach der sogenannten Einstreutechnik und eine dafür geeignete Vorrichtung in schematischer Darstellung
- **Figur 2**: eine rasterelektronenmikroskopische Aufnahme einer typischen Ätzstruktur der Oberfläche eines Quarzglas-Bauteils,
- **Figur 4**: ein Verfahren und eine zur Durchführung des Verfahrens geeignete Vorrichtung zum Aufrauhen der Tiegel-Innenoberfläche im Bereich der Ansetzzone durch einen Partikelstrom in schematischer Darstellung, und
- **Figur 5**: in schematischer Darstellung ein Verfahren und eine dafür geeignete Vorrichtung zum Beschichten der Tiegel-Innenoberfläche im Bereich der Ansetzzone.
Anhand der in **Figur 1** schematisch dargestellten Vorrichtung wird nachfolgend die Herstellung eines Quarzglas-Tiegels nach der sogenannten Einstreutechnik näher erläutert.

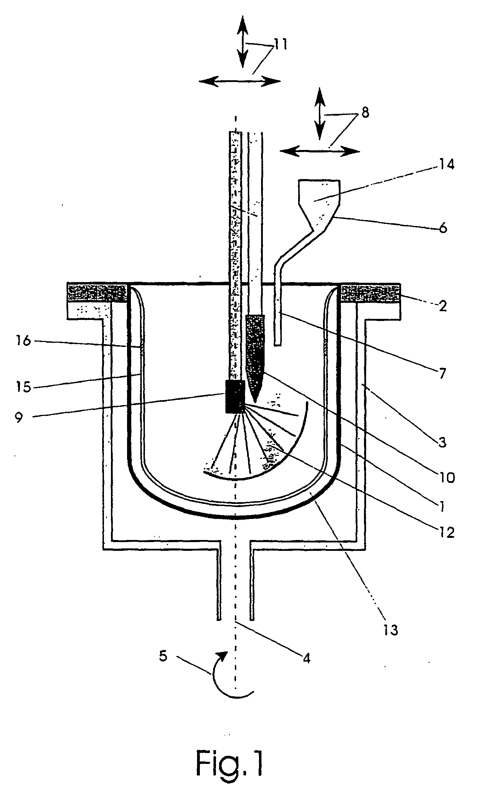

Die Vorrichtung umfaßt eine metallische Schmelzform 1, die mit einem Außenflansch 2 auf einem Träger 3 aufliegt. Der Träger 3 ist um die Mittelachse 4 rotierbar (die Rotationsrichtung ist in Figur 1 mit dem Richtungspfeil 5 bezeichnet). In die Schmelzform 1 ragt ein mit einem Vorratsbehälter 6 für SiO₂-Körnung verbundenes Einstreurohr 7, das, wie anhand der Richtungspfeile 8 dargestellt, in x- und y-Richtung verfahrbar ist. Weiterhin umfaßt die Vorrichtung ein Elektrodenpaar aus Anode 9 und Kathode 10, das ebenfalls in x- und y-Richtung verfahrbar ist und durch das im Betriebszustand ein Plasma 12 gezündet wird.

In einem ersten Verfahrensschritt wird Körnung aus natürlichem Quarz in die um ihre Mittelachse 4 rotierende Schmelzform 1 eingestreut. Dabei wird eine gleichmäßig dicke Quarzkömungs-Schicht 13 geformt, die aufgrund von Zentrifugalkräften an der Innenwandung der Schmelzform 1 stabilisiert wird.

In einem zweiten Verfahrensschritt wird Körnung 14 aus synthetisch hergestelltem SiO₂ in die rotierende Schmelzform 1 eingestreut, während das Einstreurohr 7 kontinuierlich von unten nach oben oder von links nach rechts verfahren wird. Dabei bildet sich an der Innenwandung der Quarzkörnungs-Schicht 13 eine Körnungsschicht aus SiO₂, die durch die Hitze des Plasmas zu einer transparenten Innenschicht 15 auch hochreinem SiO₂ aufgeschmolzen und dabei gleichzeitig flammenpoliert wird. Dabei wird die Quarzkörnungs-Schicht 13 zu einer opaken Außenschicht verfestigt. Anschließend kühlt der so hergestellte Quarzglas-Tiegel ab.

Im fertigen Quarzglas-Tiegel liegt die Dicke der opaken Außenschicht bei ca. 5 - 20 mm und die Dicke der Innenschicht 15 aus synthetisch hergestelltem SiO₂ bei etwa 2,5 mm. Die glatte, transparente Innenschicht 15 zeichnet sich durch hohe mechanische, thermische und chemische Festigkeit aus.

In einem dritten Verfahrensschritt wird die Oberfläche der Innenschicht 15 im Bereich einer umlaufenden Ansetzzone 16 aufgerauht. Die Ansetzzone umfaßt denjenigen Bereich der Tiegel-Innenoberfläche, in dem beim bestimmungsgemäßen Einsatz des Quarzglas-Tiegels zum Ziehen von Einkristallen der Schmelzspiegel angreift. Die Ansetzzone 16 befindet sich üblicherweise im oberen Drittel des Quarzglas-Tiegels, wie dies in Figur 1 durch eine schraffierte Fläche schematisch dargestellt ist. Um Veränderungen des Schmelzspiegels zu berücksichtigen, beträgt die Höhe der Ansetzzone 16 mindestens einige Millimeter.

Im folgenden werden unterschiedliche Verfahrensweisen zum Aufrauhen der Oberfläche der Innenschicht 15 - wenigstens im Bereich der Ansetzzone 16 - näher erläutert:

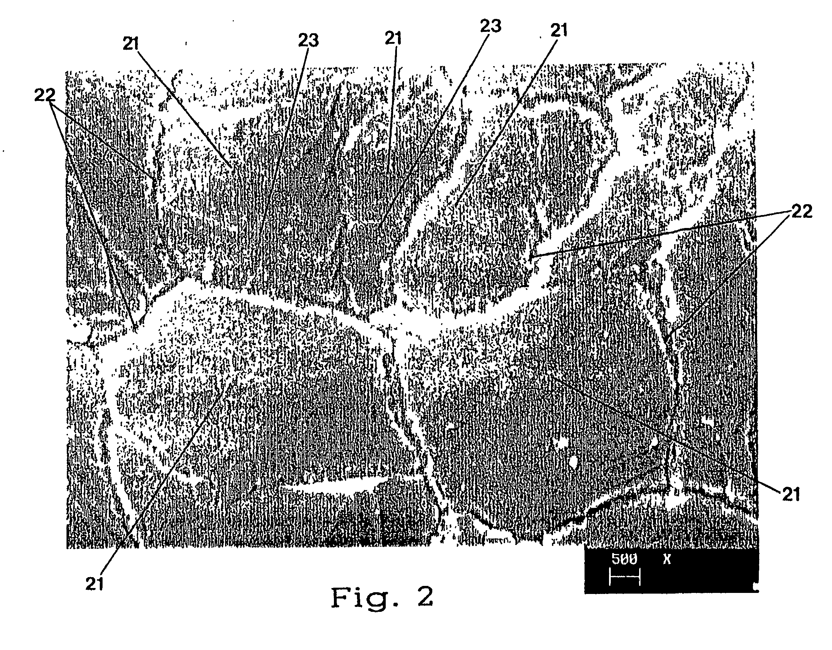

Nach einer ersten Verfahrensweise wird die Oberfläche der Innenschicht 15 durch chemisches Ätzen aufgerauht. Dadurch entsteht eine Ätzstruktur im Bereich der gesamten Innenoberfläche des Quarzglas-Tiegels, wie sie die rasterelektronenmikroskopische Aufnahme gemäß **Figur 2** zeigt.

Als günstig hat sich eine Innenoberfläche mit einer mittleren Rauhigkeit Rₐ von mindestens 2 µm im Bereich der Ansetzzone erwiesen, wobei der Wert für die mittlere Rauhtiefe Rₐ wird entsprechend DIN 4768 ermittelt wird. Aus der rasterelektronenmikroskopischen Aufnahme gemäß **Figur 2** ist ersichtlich, daß die Oberfläche durch eine Vielzahl von Erhebungen 21 mit unregelmäßigen Begrenzungslinien charakterisiert ist. Die Erhebungen weisen scharfe Ecken und Kanten auf, die durch Gräben 22 voneinander getrennt sind. Die Erhebungen 21 erscheinen in der Aufnahme als dunkle Flächen, die Gräben 22 als helle Begrenzungslinien. Bei dem konkreten Ausführungsbeispiel ergibt sich eine mittlere Größe der Erhebungen 21 von ca. 100 µm. Der Wert Rₐ beträgt bei der in Figur 2 dargestellten Oberfläche ca. 2 µm.

In der Aufnahme sind im wesentlichen fünf unregelmäßige, pyramidenstumpfartige Erhebungen 21 zu erkennen. Teilweise sind die Erhebungen 21 mit einer ausgeprägten Deckfläche in Form eines Polygons ausgebildet, das von schräg nach unten verlaufenden Seitenwänden 23 begrenzt ist, die zum Teil deutlich erkennbar stufig ausgebildet sind. Die Tiefen der einzelnen Stufen ist nicht einheitlich; im Mittel beträgt die Tiefe ca. 1 µm. Die Höhe der einzelnen Stufen variiert ebenfalls. Die einzelnen Erhebungen 21 sind durch Gräben 22 voneinander getrennt, die im Mittel eine Breite "D" um 2 µm haben. Ihre Grundfläche ist im Ausführungsbeispiel nicht eben, sondern aufgrund einer Vielzahl aneinandergrenzender, kleiner Grübchen mit Durchmessern von weniger als 1 µm unregelmäßig gestaltet.

Für die Herstellung der in Figur 2 dargestellten Oberfläche wird die vorab flammenpolierte Oberfläche der Innenschicht 15 in Alkohollösung und anschließend in flußsäurehaltiger Ätrlösung gereinigt. Eine saubere und homogene Oberfläche trägt zur Erzeugung einer gleichmäßigen Rauhigkeit und der oben erläuterten feinkörnigen Mikrostruktur über die gesamte Tiegel-Innenoberfläche bei.

Es wird eine Ätzlösung mit der nachfolgend angegebenen Zusammensetzung hergestellt:
23,6 Gew.-% HF (eingewogen als 50%ige HF-Lösung),
17,4 Gew.-% Ammoniumfluorid (eingewogen als Feststoff)
35,4 Gew.-% Essigsäure (eingewogen als 100%ige Essigsäure; Eisessig)
und 23,6 Gew.-% Wasser.

Die Ätzlösung wird durch einstündiges Ruhenlassen stabilisiert. Auch die Stabilisierung der Ätzlösung trägt zur Erzeugung einer gleichmäßigen Rauhigkeit und der oben erläuterten feinkömigen Mikrostruktur über die gesamte Tiegel-Innenoberfläche bei. Nach Temperierung des Tiegels auf ca. 15°C, wird dieser in die Ätzlösung eingetaucht. Bei einer Temperatur der Ätzlösung von 15°C beträgt die Behandlungsdauer 60 Minuten. Anschließend wird die Innenschicht 15 zehn Minuten lang in 5-%iger Flußsäurelösung nachgereinigt. Nach diesem Ätz- und Reinigungsprozeß weist die gesamte Innenoberfläche die in Figuren 2 gezeigte Mikrostruktur auf.

Sofern bei den folgenden Figurenbeschreibungen dieselben Bezugsziffem wie bei der Beschreibung der Vorrichtung nach Figur 1 verwendet werden, so sollen damit gleiche oder äquivalente Bestandteile der Vorrichtung bezeichnet sein, wie sie oben anhand der Beschreibung zu Figur 1 näher erläutert sind.

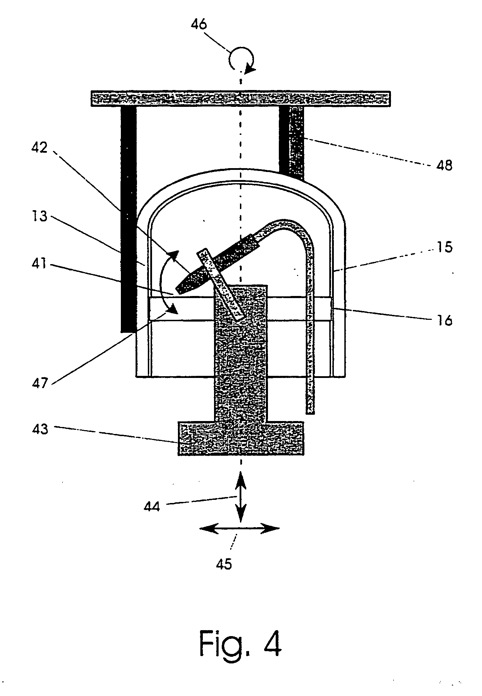

In **Figur 4** ist ein alternatives Verfahren zum Aufrauhen der Tiegel-Innenoberfläche im Bereich der Ansetzzone 16 und eine dafür geeignete Vorrichtung schematisch dargestellt. Das Aufrauhen erfolgt hier durch einen Strom aus gefrorenen CO₂-Kügelchen 41 ähnlich einem Sandstrahlverfahren. Der Strom aus gefrorenen CO₂-Kügelchen 41 wird mittels einer an einer Aufhängung 43 geführten Düse 42 gegen die Innenwandung 15 im Bereich der Ansetzzone 16 gerichtet. Mittels eines Dreibackenfutters 48 wird der Tiegel eingespannt und um seine Mittelachse rotiert (Richtungspfeil 46). Die Düse 42 ist nach oben und unten (Richtungspfeil 44) und seitlich (Richtungspfeil 45) bewegbar und außerdem zur Tiegel-Mittelachse schwenkbar, wie dies mit dem Richtungspfeil 47 angedeutet ist. Somit kann die Düse 42 auf jeden Punkt im Bereich der Seitenwand des Tiegels gerichtet werden. Die bei dieser Verfahrensweise erzeugte mittlere Rauhtiefe im Bereich der Ansetzzone 16 hängt im wesentlichen von der kinetischen Energie der CO₂-Kügelchen 41 und der Behandlungsdauer ab. Im Ausführungsbeispiel ergab sich bei Behandlung mit einer mittleren Partikelgröße der CO₂-Kügelchen 41 von ca. 100 µm, einem Druck von 3 bar und einem Abstand zwischen Düse 42 und Tiegelwand von ca. 5 cm nach einer Behandlungsdauer von 10 Minuten im Bereich der Ansetzzone 16 eine mittlere Rauhtiefe Rₐ von 20 µm. Die dadurch erzeugten Vertiefungen sind statistisch verteilt und überschneiden sich teilweise. Der Abstand zwischen benachbarten Vertiefungen ist in jedem Fall kleiner als 100 µm. Alternativ hierzu wird im Bereich der Ansetzzone 16 eine mittlere Rauhigkeit Rₐ von 15 µm durch Bestrahlung mit einem handelsüblichen CO₂-Laser erzeugt, der anstelle der Düse 42 an der Aufhängevorrichtung 43 bewegbar gehalten wird.

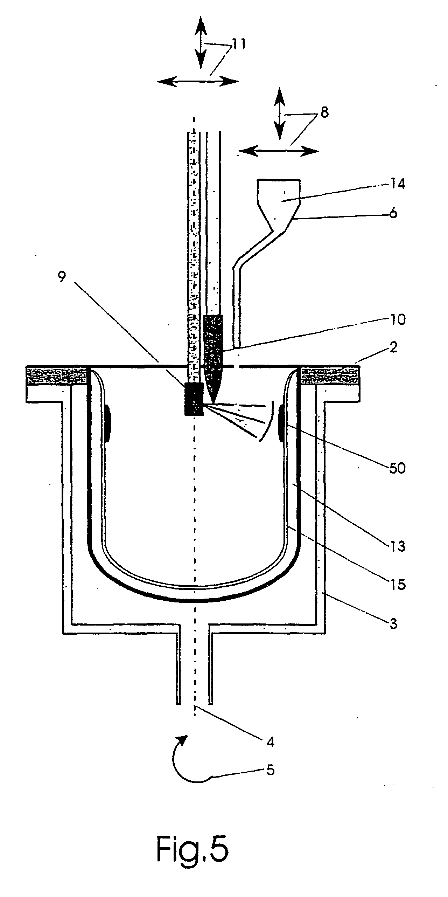

In **Figur 5** ist ein weiteres Verfahren zum Aufrauhen der Tiegel-Innenoberfläche im Bereich der Ansetzzone und eine dafür geeignete Vorrichtung schematisch dargestellt. Das Aufrauhen erfolgt hier dadurch, daß im Bereich der Ansetzzone eine rauhe Oberflächenschicht 50 gebildet wird. Die Oberflächenschicht 50 wird analog zum oben näher erläuterten Einstreuverfahren entweder auf der Innenschicht 15 erzeugt (wie im in Figur 6 dargestellten Ausführungsbeispiel) oder anstelle der Innenschicht 15. Bei beiden Varianten wird der synthetischen SiO₂-Körnung eine Zusatzkomponente beigemischt, und zwar 0,1 - 2 Gew.-% Si₃N₄. Diese Zusatzkomponente zersetzt sich beim Erhitzen unter Freisetzung stickstoffhaltiger Gase, so daß nach dem Verglasen eine blasenhaltige Oberflächenschicht 50 erhalten wird. Nach dem Öffnen der Blasen, beispielsweise durch Anätzen, liegt die mittlere Rauhtiefe Rₐ der Oberflächenschicht 50 bei ca. 100 µm. Die Dichte, mit der die Blasen die Oberfläche belegen hängt von der Menge der Zusatzkomponente ab. Der Abstand zwischen benachbarten Blasen liegt unterhalb von 5 mm.

Bei den nach den erfindungsgemäßen Verfahren hergestellten Quarzglas-Tiegeln gelingt das Ansetzen des Impfkristalls zum anschließenden Ziehen des Einkristalls nahezu immer beim sten Versuch, während bei anderen Quarzglas-Tiegeln häufig mehrere Anläufe erforderlich sind. Vermutlich beruht dieser Effekt auf einer Unterdrückung von Oberflächenvibrationen der Metallschmelze, die sich aufgrund der Wechselwirkung zwischen Metallschmelze, Tiegelwandung und Gasphase ausbilden können.

## Patentansprüche

1. Verfahren zur Herstellung eines Quarzglas-Tiegels durch Bereitstellen eines Tiegelkörpers mit einer Innenoberfläche aus Quarzglas, **dadurch gekennzeichnet, daß** die Innenoberfläche (15) im Bereich einer Ansetzzone (16) durch Ätzen mittels einer Ätzlösung aufgerauht wird, wobei eine Vielzahl von Vertiefungen, die einen Abstand von maximal 5 mm zueinander haben, ausgebildet werden.

2. Verfahren zur Herstellung eines Quarzglas-Tiegels durch Bereitstellen eines Tiegelkörpers mit einer Innenoberfläche aus Quarzglas, **dadurch gekennzeichnet, daß** das Bereitstellen des Tiegelkörpers ein Einstreuen von SiO₂-Körnung (14) in eine Schmelzform (1) umfaßt, und daß der SiO₂-Körnung (14) eine Zusatzkomponente beigemischt wird, die beim Erhitzen unter Freisetzung eines Gases reagiert, wobei durch die Freisetzung des Gases eine porenhaltige Blasenschicht im Bereich der Ansetzzone (16) erzeugt wird, die nach dem Öffnen der Blasen eine Vielzahl von Vertiefungen freilegt.

3. Verfahren zur Herstellung eines Quarzglas-Tiegels durch Bereitstellen eines Tiegelkörpers mit einer Innenoberfläche aus Quarzglas **dadurch gekennzeichnet, daß** in der Innenoberfläche (15) Kratzer durch Einwirkung eines Partikelstromes aus gefrorenen CO₂-Pellets auf der Oberfläche erzeugt werden.

4. Verfahren nach einem der Ansprüche 1 bis 3, **dadurch gekennzeichnet, daß** die Aufrauhung durch eine Vielzahl von Vertiefungen, die einen Abstand von maximal 1 mm, vorzugsweise maximal 100 µm zueinander haben, erzeugt wird.

5. Verfahren nach einem der Ansprüche 1 bis 4, **dadurch gekennzeichnet, daß** die Innenoberfläche (15) aus synthetischen Quarzglas erzeugt wird.

## Claims

1. A process for manufacturing a quartz glass crucible by providing a crucible body with an inner surface of quartz glass, **characterized in that** the inner surface (15) is roughened in the area of an initiation zone (16) by etching by means of an etching solution, wherein a plurality of recesses are formed having a distance of not more than 5 mm from one another.

2. The process for manufacturing a quartz glass crucible by providing a crucible body having an inner surface of quartz glass, **characterized in that** the provision of the crucible body comprises spreading SiO₂ granules (14) into a melting mold (1), and that the SiO₂ granules (14) have added thereto an additional component which upon heating reacts with release of a gas, the release of said gas producing a pore-containing bubble layer in the area of the initiation zone (16) which exposes a plurality of recesses after the bubbles have been opened.

3. The process for manufacturing a quartz glass crucible by providing a crucible body having an inner surface of quartz glass, **characterized in that** in the inner surface (15) scratches are produced by the action of a particle stream of frozen CO₂ pellets on the surface.

4. The process according to any one of claims 1 to 3, **characterized in that** the roughening is produced through a plurality of recesses having a distance of not more than 1 mm, preferably not more than 100 µm, from one another.

5. The process according to any one of claims 1 to 4, **characterized in that** the inner surface (15) is made from synthetic quartz glass.

## Revendications

1. Procédé pour la fabrication d'un creuset en verre de quartz par préparation d'un corps de creuset avec une surface interne en verre de quartz, **caractérisé en ce que** la surface interne (15) est rendue rugueuse à proximité d'une zone d'adhérence (16) par attaque au moyen d'une solution mordante, un grand nombre de cavités à distance de maximum 5 mm entre elles étant formées.

2. Procédé pour la fabrication d'un creuset en verre d quartz par préparation d'un corps de creuset avec une surface interne en verre de quartz, **caractérisé en ce que** la préparation du corps de creuset comprend un versement de granulé de SiO₂ (14) dans un moule de fusion (1) et **en ce que** le granulé SiO₂ (14) est mélangé à un composant additionnel qui réagit lors de la montée en température en libérant un gaz, la libération du gaz formant une couche alvéolaire à proximité de la zone de collage (16) qui dégage après l'ouverture des alvéoles un grand nombre de cavités.

3. Procédé pour la fabrication d'un creuset en verre de quartz par préparation d'un corps de creuset avec une surface interne en verre de quartz, **caractérisé en ce que** dans la surface interne (15) des éraflures sont provoquées à la surface par action d'un courant de particules de boulettes de C02.

4. Procédé selon l'une des revendications 1 à 3, **caractérisé en ce que** la rugosité est réalisée par un grand nombre de cavités qui ont une distance de maximum 1 mm de préférence maximum 100 µm entre elles.

5. Procédé selon l'une des revendications 1 à 4, **caractérisé en ce que** la surface interne (15) est réalisée en verre de quartz synthétique.
